# EUROPÄISCHE PATENTSCHRIFT

(11) **EP 4 113 871 B1**
(45) Veröffentlichungstag und Bekanntmachung des Hinweises auf die Patenterteilung: **23.10.2024**
(21) Anmeldenummer: 22181721.6
(22) Anmeldetag: 29.06.2022
(51) Int. Cl.: H04J 3/06

(54) **SIGNALEMPFANG MIT HOHER AUFLÖSUNG**
SIGNAL RECEPTION WITH HIGH RESOLUTION
RÉCEPTION DE SIGNAUX À HAUTE RÉSOLUTION

(30) Priorität: 01.07.2021 AT 505492021
(43) Veröffentlichungstag der Anmeldung: 04.01.2023
(73) Patentinhaber: B&R Industrial Automation GmbH, 5142 Eggelsberg (AT)
(72) Erfinder: Weber, Horst, 5142 Eggelsberg (AT); Meisl, Franz, 5142 Eggelsberg (AT)
(74) Vertreter: Patentanwälte Pinter & Weiss OG

(56) Entgegenhaltungen:
- EP-A1- 3 404 866
- WO-A1-2020/261066
- US-A1- 2018 343 183
- US-B1- 7 451 337
- RAMÃ3N J ALIAGA ET AL: "PET System Synchronization and Timing Resolution Using High-Speed Data Links", IEEE TRANSACTIONS ON NUCLEAR SCIENCE, IEEE, USA, vol. 58, no. 4, 1 August 2011 (2011-08-01), pages 1596 - 1605, XP011373129, ISSN: 0018-9499, DOI: 10.1109/TNS.2011.2140130

## Beschreibung

Die gegenständliche Erfindung betrifft ein Verfahren zum Empfang eines Signals durch einen Teilnehmer eines Echtzeit-Netzwerks, wobei das Signal einen Signaltakt mit einer Signaltaktfrequenz aufweist und der Teilnehmer einen Zähler umfasst, welcher einen Zählertakt mit einer Zählertaktfrequenz aufweist und eine lokale Zeit des Teilnehmers abbildet.

In einem Echtzeit-Netzwerk werden Daten in Form von digitalen Signalen zwischen Teilnehmern übertragen. Ein sendender Teilnehmer umfasst einen ersten Zähler mit einem ersten Zählertakt aufweisend eine erste Taktfrequenz, ein empfangender Teilnehmer einen zweiten Zähler mit einem zweiten Zählertakt aufweisend eine zweite Taktfrequenz. Dabei stimmt oftmals die zweite Taktfrequenz nicht mit der ersten Taktfrequenz überein, d.h. ist weder synchron noch phasengleich. Ein Zähler erhöht seinen Zählerstand im Zählertakt mit der zugehörigen Taktfrequenz, wobei auch die Taktperiode als Inverse der Taktfrequenz angesehen werden kann. In dieser Betrachtungsweise erhöht der Zähler seinen Zählerstand jede Taktperiode.

Der sendende Teilnehmer übermittelt das digitale Signal an den empfangenden Teilnehmer. Um Information über das Signal zu übertragen, quantisiert der sendende Teilnehmer mit dem Signal zu übertragende Information zu bestimmten Zeitpunkten, wobei diese Zeitpunkte im Signaltakt von einer Signaltaktfrequenz vorgegeben werden. Damit sind die quantisierten Werte des Signals mit der Signaltaktperiode beabstandet. Da der sendende Teilnehmer einen ersten Zähler umfasst, verwendet er die erste Taktfrequenz des ersten Zählers für die Signaltaktfrequenz. Das Signal wird vom empfangenden Teilnehmer mit einer Abtasttaktfrequenz abgetastet, um das Signal zu quantisieren. Da der empfangende Teilnehmer einen zweiten Zähler umfasst, verwendet er wiederum die zweite Taktfrequenz des zweiten Zählers für die Abtasttaktfrequenz. Ist die zweite Taktfrequenz an die Signaltaktfrequenz angepasst, so kann das Signal ohne Verlust rekonstruiert werden. Bei asynchronen Übertragungen ist es auch üblich, eine Abtastfrequenz mit einem Vielfachen der Bitrate/Symbolrate durchzuführen, was als Überabtastung (over-sampling) bezeichnet wird. Dabei sind Abtastfrequenzen von bis zu einigen 100 MHz vorgesehen. Die Auflösung der Abtastung des Signals ist jedoch durch die zweite Taktfrequenz des zweiten Zählers des empfangenden Teilnehmers begrenzt. Wird beispielsweise der zweite Zähler mit einer Taktfrequenz von 125 MHz, d.h. einer zweiten Taktperiode von 8ns betrieben, so führt dies zu einer Auflösung von 8ns. Die Auflösung kann nur durch Erhöhung der Taktfrequenz verbessert werden, was jedoch nicht oder nur stark begrenzt möglich ist

Es sind Verfahren bekannt, bei welchen ein Master ein Taktsignal vorgibt, welches von einem Slave wiedergeherstellt und zum Master zurückgeführt wird. Der Master ermittelt die Abweichung des rückgeführten Takts vom ursprünglichen Takt unter Verwendung eines Phasen-Detektors und passt sein Taktsignal an, um die Abweichung zu reduzieren. Dieses Verfahren wird am CERN-Institut im Rahmen des White Rabbit Projekts entwickelt. Um eine Auflösung geringer als eine Nanosekunde zu erreichen, wird eine Erweiterung von SyncE (Synchronous Ethernet) verwendet. Damit ist eine sehr hohe Auflösung möglich. Es werden jedoch auch sehr hohe Anforderungen bezüglich Frequenzabweichung und Jitter-Verhalten an den Oszillator gestellt. Weiters können lediglich ca. 10 Teilnehmer in Reihe geschaltet werden, da die Teilnehmer immer jeweils ihr Signal mit dem Takt eines verbundenen Teilnehmers synchronisieren. Da mit dem Takt des Ports auf den die weiteren Teilnehmer synchronisiert werden sollen, auch das Signal generiert wird, das an diese Teilnehmer gesendet wird, kaskadieren sich mit der Taktsynchronisation auch negative Effekte, wie z.B. Jitter usw.

Die US 8,698,530 B2 offenbart eine globale Taktfrequenz, welche allen Teilnehmern zur Verfügung gestellt wird. Um eine höhere Auflösung zu erzielen, welche höher als die globale Auflösung auf Basis der globalen Taktfrequenz ist, wird die lokale Taktfrequenz kontinuierlich geregelt, um die Taktfrequenzen der Teilnehmer aneinander anzupassen. Hierzu werden die Zähler der Teilnehmer in unterschiedlichen Zeitdomänen betrieben, d.h. jeder Teilnehmer weist eine andere lokale Zeit auf.

Weiterhin ist aus der WO 2020/261066 A1 ein Verfahren zum Bestimmen einer Zeit in einem digitalen Verarbeitungssystem für hochpräzise Zeitstempel bekannt. Dazu sind in einem Empfänger ein Referenzzeitzähler, welcher bei jedem Zyklus einer digitalen Referenz-Clock um einen fixen Betrag erhöht wird, und ein Netzwerkzeitzähler, welcher bei jedem Zyklus einer digitalen Netzwerk-Clock um einen variablen Betrag erhöht werden kann, vorgesehen. Der variable Betrag, um welchen der Netzwerkzeit-Zähler erhöht werden kann, kann von der Referenz-Clock, welche mit einer geringeren Frequenz, aber einer höheren Genauigkeit als die Netzwerk-Clock läuft, beeinflusst werden, um den Netzwerkzeitzähler und den Referenzzeitzähler zu synchronisieren.

Es ist eine Aufgabe der gegenständlichen Erfindung, ein flexibles Verfahren zum Empfang von Signalen anzugeben.

Diese Aufgabe wird erfindungsgemäß gelöst, indem ein Empfangstakt eines Empfangszählers des Teilnehmers zur Abtastung des Signals vorgesehen ist, wobei der Empfangstakt aus dem Zählertakt abgeleitet wird, womit der Empfangszähler ebenfalls die lokale Zeit des Teilnehmers abbildet, wobei eine Phasenlage des Empfangstakts bei der Ableitung aus dem Zählertakt an die Phasenlage des Signaltakts angepasst wird und wobei das Signal mit einer Empfangstaktfrequenz des Empfangszählers abgetastet wird.

Das Signal kann nach der Abtastung weiterverarbeitet werden. Das Anpassen der Phasenlage des Empfangstakts an die Phasenlage des Signaltakts kann beispielsweise durch eine Verschiebung der Phasenlage des Empfangstakts in Richtung der Phasenlage des Signaltakts erfolgen.

Da es ohne spezielle Mechanismen nicht möglich ist, ein Signal von einer Takt-Domäne in eine andere asynchrone Takt-Domäne zu überführen (ohne Ungenauigkeiten zu erzeugen), ist erfindungsgemäß am Empfänger zur Abbildung der lokalen Zeit nicht nur der Zähler in einer Zählertaktdomäne, sondern ein zusätzlicher Empfangszähler, dessen Empfangstakt aus dem Zählertakt abgeleitet ist, in einer Empfangstaktdomäne vorgesehen. Dieser Empfangszähler ist zwar takt-asynchron, aber wert-synchron und bildet unter Berücksichtigung einer Phasenverschiebung gegenüber dem Zählertakt ebenso die lokale Zeit ab. Es ist am Teilnehmer somit nicht nur ein Zählertakt mit einer Zählertaktfrequenz zur Abbildung der lokalen Zeit vorgesehen, sondern zusätzlich ein Empfangszähler mit einer Empfangstaktfrequenz. Nachdem der Zeitstempel in der Empfangstaktdomäne gebildet wurde, kann die Information über eine Schnittstelle in die Zählertaktdomäne übertragen werden. Es ist somit wünschenswert, eine ausreichend geringe Phasenverschiebung zwischen dem Zählertakt und Empfangstakt zu gewährleisten, damit die Zeitinformation der beiden Domänen synchronisiert werden.

Vorzugsweise wird der Empfangstakt unter Verwendung einer Phase-Locked-Loop aus dem Zählertakt abgeleitet.

Die Empfangstaktfrequenz kann der Zählertaktfrequenz entsprechen. Vorzugsweise ist die Empfangstaktfrequenz jedoch ein Vielfaches der Zählertaktfrequenz, womit der Empfangszähler ein Vielfaches der Auflösung des Zählers aufweist, da das Signal mit einer höheren Bitrate abgetastet werden kann.

Es kann davon ausgegangen werden, dass die Empfangstaktfrequenz sich von der Signaltaktfrequenz zumindest geringfügig unterscheidet, weshalb der Empfangstakt und Signaltakt auseinanderdriften, was zu einer Phasenverschiebung führt. Dies kann durch eine einmalige Anpassung der Phasenlage des Empfangstakts an den Signaltakt zumindest temporär behoben werden. Es ist vorteilhaft, auch den Zählerstand des Empfangszählers an die angepasste Phasenlage anzupassen, womit der Quantisierungszeitpunkt des Empfangszählers verändert und das Signal mit einer geringeren Unschärfe abgetastet werden kann.

Vorzugsweise wird ein Vorzeichen einer Phasenverschiebung zwischen dem Empfangstakt und dem Signaltakt ermittelt und darauf basierend die Phasenlage des Empfangstakts verändert, um die Phasenlage des Empfangstakts an die Phasenlage des Signaltakts anzupassen. Durch die Ermittlung des Vorzeichens der Phasenverschiebung wird erkannt, in welche Richtung die Phasenlage des Empfangstakts verschoben werden muss, um die Phasenverschiebung zu verringern. Wird jedoch die Phasenlage um einen Betrag größer der Phasenverschiebung verschoben, so tritt ein Überschießen auf, womit sich wiederum das Vorzeichen der Phasenverschiebung verändert.

Die Phasenlage des Empfangstakts kann über mehrere Empfangstaktperioden verändert werden. Damit ist eine sukzessive Anpassung der Phasenlage des Empfangstakts an die Phasenlage des Signaltakts möglich. Wird die Phasenlage auf Basis des zuvor ermittelten Vorzeichens der Phasenverschiebung in eine Richtung verändert und tritt ein Überschießen auf, (d.h. die Phasendifferenz ändert ihr Vorzeichen), so wird in der nächsten Empfangstaktperiode die Phasenlage des Empfangstakts wieder in die andere Richtung verschoben, womit ein Überschießen in die andere Richtung auftreten kann. So kann der Fall eintreten, dass die Phasenlage des Empfangstakts abwechselnd in die eine und in die andere Richtung verändert wird und somit abwechselnd in beide Richtungen überschießt, d.h. um die Phasenlage der Signaltaktfrequenz pendelt.

Wird zur Erzeugung des Empfangstakts aus dem Zählertakt eine Phase Locked Loop verwendet, so ist es vorteilhaft, wenn diese sogenannte dynamic Phase-Shifts unterstützt. Die Größe dieser Phase-Shifts ist vorzugsweise konstant. Damit kann die Phasenlage des Empfangstakts zum Zählertakt (welcher als Referenztakt dient) in kleinen Schritten (<< 1 ns, abhängig vom verwendeten FPGA oder ASIC) verschoben werden, womit wiederum die Phasenlage des Empfangstakts kontinuierlich der Phasenlage des Signaltakts angepasst werden kann.

Vorzugsweise wird die Phasenlage des Empfangstakts für jede Empfangstaktperiode durch Verschiebung um ein positives oder negatives Phaseninkrement verändert. Die aktuelle Phasenlage kann anhand einer Signalflanke bestimmt werden. Bei einer 8B10B-Codierung treten beispielsweise immer Signalflanken auf. Wird weiters auf Basis des Vorzeichens der Phasenverschiebung die Phasenlage der Empfangstaktfrequenz über mehrere Empfangstaktperioden jeweils um ein Phaseninkrement verändert, so verbleibt nach ausreichend vielen Verschiebungsschritten eine Phasenabweichung kleiner eines (positiven oder negativen) Phaseninkrements.

Vorzugsweise wird der Zählerstand des Empfangszählers analog zur Phasenlage des Empfangstakts verändert. Somit wird mit dem Zählerstand der Quantisierungszeitpunkt des Empfangszählers an die lokale Zeit angepasst, womit diese korrekt quantisiert und wiedergeben wird. Es kann also mittels der Anpassung der Phasenlage des Empfangstakts an die Phasenlage des Signaltakts und der daraus folgenden Anpassung des Empfangszählers sichergestellt werden, dass das Signal mit geringen Quantisierungsfehlern abgetastet wird. Die Auflösung, mit welcher das empfangene Signal vermessen werden kann, ist damit nicht mehr direkt vom Zählertakt abhängig, sondern von der aktuell auftretenden Phasenverschiebung.

Die Signaltaktfrequenz ist vorab bekannt und kann vorzugsweise vom Teilnehmer aus dem Signal rekonstruiert werden. Ist das Signal leitungscodiert, beispielsweise mit der 8B10B-Leitungscodierung, so ist eine Rekonstruktion der Signaltaktfrequenz aus dem Signal besonders einfach möglich.

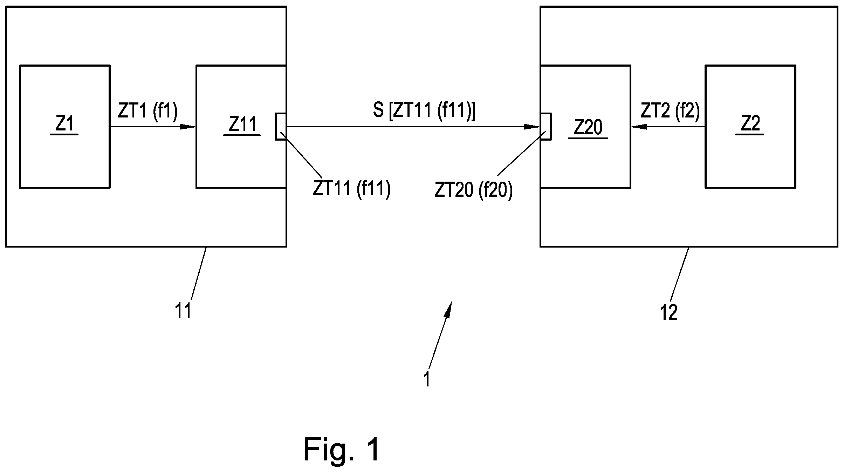

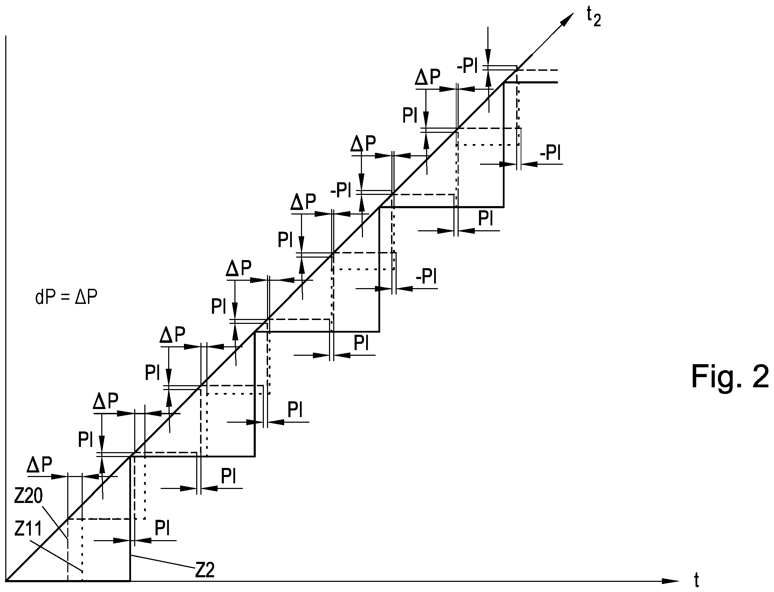

Die gegenständliche Erfindung wird nachfolgend unter Bezugnahme auf die Figuren 1 und 2 näher erläutert, die beispielhaft, schematisch und nicht einschränkend vorteilhafte Ausgestaltungen der Erfindung zeigen. Dabei zeigt
- Fig.1: ein beispielhaftes Echtzeit-Netzwerk,
- Fig.2: eine Anpassung des Zählertakts an die Phasenverschiebung.

In Fig. 1 ist ein Echtzeit-Netzwerk 1 dargestellt, wobei hier nur beispielhaft zwei Teilnehmer 11, 12 abgebildet sind. Ein sendender Teilnehmer 11 umfasst einen ersten Zähler Z1 mit einem zugehörigen ersten Zählertakt ZT1, wobei der erste Zählertakt ZT1 eine erste Taktfrequenz f1 aufweist. Der Zählerstand des ersten Zählers Z1 erhöht sich mit dem erstem Zählertakt ZT1 und bildet somit eine erste lokale Zeit t1 des ersten Teilnehmers 11 ab. Die erste lokale Zeit t1 des ersten Teilnehmers 11 ist somit mit dem ersten Zählertakt ZT1 des ersten Teilnehmers 11 quantisiert.

Der erste Teilnehmer 11 umfasst weiters einen Sendezähler Z11, welcher einen Sendetakt ZT11 aufweist. Der Sendetakt ZT11 wird aus dem ersten Zählertakt ZT1 abgeleitet und kann beispielsweise einem Vielfachen davon entsprechen. Der Sendetakt ZT11 weist eine Sendetaktfrequenz f11 auf.

Der zweite Teilnehmer 12 umfasst einen zweiten Zähler Z2 mit einem zugehörigen zweiten Zählertakt ZT2, welcher eine zweite Taktfrequenz f2 aufweist. Der Zählerstand des zweiten Zählers Z2 erhöht sich mit dem zweiten Zählertakt ZT2 und bildet somit eine zweite lokale Zeit t2 des zweiten Teilnehmers 12 ab, wobei die zweite lokale Zeit t2 des zweiten Teilnehmers 12 mit dem zweiten Zählertakt ZT2 quantisiert ist.

Es kann eine erste Taktperiodendauer T1 als Inverse der ersten Taktfrequenz f1 und eine zweite Taktperiodendauer T2 als Inverse der zweiten Taktfrequenz f2 angesehen werden.

Der sendende Teilnehmer 11 übermittelt ein Signal S an den empfangenden Teilnehmer 12, wobei das Signal S mit dem ersten Sendetakt ZT11 des ersten Teilnehmers 11 quantisiert ist. Der erste Sendetakt ZT11 wird somit in Folge als Signaltakt ZT11 bezeichnet und die erste Sendetaktfrequenz f11 als Signaltaktfrequenz f11 bezeichnet.

Da in Folge der Empfang des Signals S durch den zweiten Teilnehmer 12 betrachtet wird, wird der zweite Teilnehmer 12 lediglich als Teilnehmer 12 bezeichnet, der zweite Zähler Z2 als Zähler Z2, der zweite Zählertakt ZT2 als Zählertakt ZT2, die zugehörige zweite Zählertaktfrequenz f2 als Zähleraktfrequenz f2 und die zweite lokale Zeit t2 als lokale Zeit t2.

Erfindungsgemäß weist der Teilnehmer 12 neben dem Zähler Z2 einen Empfangszähler Z20 auf. Der Empfangszähler Z20 hat einen Empfangstakt ZT20 mit einer Empfangstaktfrequenz f20, wobei sich der Zählerstand des Empfangszählers Z20 mit dem Empfangstakt ZT20 erhöht. Der Empfangstakt ZT20 ist zur Abtastung des Signals S vorgesehen und wird aus dem Zählertakt Z2 abgeleitet. Damit bildet der Empfangszähler Z20 die lokale Zeit t2 des Teilnehmers 12 ab, womit die lokale Zeit t2 auch mit der Empfangstaktfrequenz f20 quantisiert ist.

Vorzugweise wird der Empfangstakt ZT20 mittels einer Phase-Locked-Loop aus dem Zählertakt ZT2 gebildet.

Da der Empfangstakt ZT20 jedoch für die Abtastung des Signals S vorgesehen ist, wird die Phasenlage des Empfangstakts ZT20 bei der Ableitung aus dem Zählertakt ZT2 an die Phasenlage des Signaltakts ZT11 angepasst. Damit wird das Signal S mit einem geringen Quantisierungsfehler durch den Empfangstakt ZT20 abgetastet.

Die Zählertaktfrequenz f2 und die Empfangstaktfrequenz f20 müssen jedoch nicht übereinstimmen, vielmehr kann die Empfangstaktfrequenz f20 ein Vielfaches von der Zählertaktfrequenz f2 sein. Vorzugsweise entspricht die Zählertaktfrequenz f2 der Symboltaktfrequenz des Signals S, wobei die Symboltaktfrequenz ein x-tel der Signaltaktfrequenz f11 beträgt, wobei x die Anzahl der Bits pro Symbol darstellt. Für eine 8B10B-Codierung ist beispielsweise x=10 Bits pro Symbol vorgesehen, womit sich bei einer Signaltaktfrequenz f11 von 512 MHz eine Symboltaktfrequenz von 51,2 MHz ergibt. Ist eine einfache Datenrate vorgesehen (SDR - single data rate), so entspricht die Empfangstaktfrequenz f20 der Signaltaktfrequenz f11. Bei einer doppelten Datenrate (DDR - double data rate) entspricht die Empfangstaktfrequenz f20 der halben Signaltaktfrequenz f11. Damit ergibt sich bei einer Signaltaktfrequenz f11 von 512 M Hz eine Empfangstaktfrequenz f20 von 256 MHz.

Die Auflösung eines Zählers entspricht üblicherweise der Taktperiode des zugehörigen Zählers, bei einem Zähler mit einer Taktperiode von 20ns also einer Auflösung von 20ns.

In Fig. 2 ist auf der Abszisse die reale Zeit t dargestellt. Auf der Ordinate sind der Zählerstand des Zählers Z2 sowie des Empfangszählers Z20 und auch der Signaltakt ZT11 als Treppenstufen dargestellt. Jede Treppenstufe des Zählers Z2 bedeutet eine Erhöhung des zugehörigen Zählerstands und jede Treppenstufe des Empfangszählers Z20 eine Erhöhung des zugehörigen Zählerstands.

Die nicht quantisierte lokale Zeit t2 ist als Gerade dargestellt. Der Zähler Z2 erhöht seinen Zählerstand mit dem Zählertakt ZT2, d.h. mit der Zählertaktfrequenz f2 (oder anders formuliert jede Zählertaktperiode T2) um eine Mehrzahl Zählerinkremente I2. Die Anzahl der Zählerinkremente I2 ist abhängig von der Dauer eines Zählerinkrements I2 und der gewünschten Zählertaktperiode T2. Die zweite lokale Zeit t2 wird nur in den Momenten dieser Erhöhung des Zählerstands genau wiedergegeben. Die lokale Zeit t2 wird durch den Zähler Z2 also nur dann exakt wiedergegeben, wenn der Zähler Z2 die lokale Zeit t2 schneidet. Zu allen anderen Zeitpunkten weist der Zähler Z2 Quantisierungsfehler auf.

Der zweite Teilnehmer 12 empfängt ein Signal S, welches mit dem Signaltakt ZT11, d.h. mit der Signaltaktfrequenz f11, quantisiert ist. Erfindungsgemäß wird ein Empfangstakt ZT20 eines Empfangszählers Z20 aus dem Zählertakt ZT2 abgeleitet, wobei die Empfangstaktfrequenz f20 des Empfangstakts ZT20 mit der Zählertaktfrequenz f2 des Zählertakts ZT2 übereinstimmt oder ein Vielfaches davon ist. Der Empfangszähler Z20 erhöht seinen Zählerstand mit dem Empfangstakt ZT20, d.h. mit der Empfangstaktfrequenz f20 oder anders formuliert jede Empfangstaktperiode T2 um eine Mehrzahl Empfangszählerinkremente I20, wobei die Anzahl der Empfangszählerinkremente I20 von der Dauer eines Empfangszählerinkrements I20 und der gewünschten Empfangszählertaktperiode T2 abhängig ist.

Der Empfangszähler Z20 ist in Fig. 2 strichliert dargestellt. Weiters ist in Fig. 2 der Signaltakt ZT11 punktiert dargestellt. Der Signaltakt ZT11 und damit auch die Signaltaktfrequenz f11 können dem zweiten Teilnehmer 12 unbekannt oder auch bekannt sein. Die (Nenn-) Signaltaktfrequenz f11 ist dem Teilnehmer 12 jedoch vorzugsweise vorab bekannt.

Die Empfangstaktfrequenz f20 entspricht im dargestellten Beispiel der doppelten Zählertaktfrequenz f2, womit die Empfangstaktperiode T20 der halben Zählertaktperiode T2 entspricht. Es ist vorteilhaft, wenn die Empfangstaktfrequenz f20 ein Vielfaches, z.B. ein Fünffaches, der Zählertaktfrequenz f2 ist, womit auch die Auflösung des Empfangszählers Z20 ein Vielfaches des Zählers Z2 beträgt und das Signal S mit dieser erhöhten Auflösung abgetastet werden kann.

Der Empfangszähler Z20 erhöht seinen Zählerstand mit der Empfangstaktfrequenz f20, also pro Empfangstaktperiode T20 um eine Mehrzahl an Empfangszählerinkrementen I20, wobei die lokale Zeit t2 nur in diesen Momenten genau wiedergegeben wird, also nur dann, wenn in Fig. 2 der Empfangszähler Z20 die lokale Zeit t2 schneidet.

Unter realen Bedingungen ist von einer Phasenverschiebung dP auszugehen, weshalb die Veränderung des Zählerstands des Empfangszählers Z20 zu geringfügig anderen Zeitpunkten stattfindet, als eine Veränderung des Zählerstands des Zählers Z2. Es ist auch davon auszugehen, dass die Empfangstaktfrequenz f20 sich unter realen Bedingungen von der Signaltaktfrequenz f11 unterscheidet.

Deshalb wird erfindungsgemäß die Phasenlage der Empfangstaktfrequenz f20 (und der Empfangstaktperiode T20) an die Phase der Phasenlage der Signaltaktperiode T11 (und damit der der Signaltaktfrequenz f11) angepasst. Es kann der Fall eintreten, dass die absolute Phasenverschiebung dP zwischen der Empfangstaktperiode T20 und der Signaltaktperiode T11 nicht bekannt ist, wobei jedoch das Vorzeichen der Phasenverschiebung dP bekannt ist. Hierzu kann beispielsweise festgestellt werden, ob sich bei einer Veränderung der Empfangstaktperiode T20 die Phasenverschiebung dP vergrößert oder verkleinert. Damit kann darauf geschlossen werden, ob die Phasenverschiebung dP zwischen der Empfangstaktperiode T20 und der Signaltaktperiode T11 positiv oder negativ ist.

Es erfolgt somit eine Synchronisation der Empfangstaktperiode T20 an die Signaltaktperiode T11. Es ist davon auszugehen, dass trotz Synchronisation eine absolute Phasenverschiebung dP verbleibt, woraus sich nach der Synchronisation ein geringer Quantisierungsfehler ergibt. Um sicherzustellen, dass die Signaltaktperiode T11 und Empfangstaktperiode T20 nicht auseinanderlaufen, ist es vorteilhaft, wenn die Synchronisation permanent erfolgt.

Die Phasenlage des Empfangstakts wird vorzugsweise um ein Phaseninkrement PI in der Höhe eines Zählerinkrements I10 des Empfangszählers Z20 verschoben. Die Bestimmung des Vorzeichens der Phasenverschiebung dP erfolgt beispielsweise mittels eines Phasendetektors. Das Vorzeichen der Phasenverschiebung dP kann beispielsweise bestimmt werden, indem erst die Phase des Empfangstakts in eine Richtung verschoben wird und daraufhin bestimmt wird, ob sich die Phasenverschiebung dP vergrößert oder verringert hat. Es kann somit nach jedem Einbringen eines Phaseninkrements PI bestimmt werden, ob in der nächsten Empfangstaktperiode T20 ein positives oder negatives Phaseninkrement PI hinzugefügt wird. Ist die Phasenverschiebung dP beispielsweise negativ, jedoch geringer als ein Phaseninkrement PI, so wird nach einem Hinzufügen eines positiven Phaseninkrements PI eine positive Phasenverschiebung dP (welche ebenso geringer als ein Phaseninkrement PI ist) entstehen. Deswegen wird in der nächsten Empfangstaktperiode T20 ein negatives Phaseninkrement -PI hinzugefügt, etc. Dieses abwechselnde Hinzufügen von positiven und negativen Phaseninkrementen würde beispielsweise permanent erfolgen, wenn die Empfangstaktperiode T20 exakt der Signaltaktperiode T11 entspricht, jedoch eine Phasenverschiebung dP kleiner einem Phaseninkrement PI verbleibt.

In Fig. 2 tritt anfangs eine negative Phasenverschiebung dP, welche betragsmäßig beispielhafterweise dreieinhalb Phaseninkrementen Pl entspricht und somit betragsmäßig größer einem Phaseninkrement PI ist, auf, weshalb in der zweiten dargestellten Empfangstaktperiode T20 ein Phaseninkrement Pl hinzugefügt wird. Es wird in den nächsten beiden Empfangstaktperioden T20 festgestellt, dass die Phasenverschiebung dP jeweils weiterhin negativ ist, weshalb die Phase der Empfangstaktperiode T20 jeweils um ein weiteres positives Phaseninkrement Pl verschoben wird. Somit wird die Phasenverschiebung dP sukzessive auf minus zweieinhalb Phaseninkremente PI, minus eineinhalb Phaseninkremente PI und abschließend minus ein halbes Phaseninkrement PI reduziert. Nachdem ein weiteres Phaseninkrement PI hinzugefügt wurde, tritt eine Phasenverschiebung dP von einem halben Phaseninkrement Pl auf.

Nun ist der Einschwingvorgang abgeschlossen, da die Phasenverschiebung dP positiv ist und somit das Vorzeichen geändert hat. In der nächsten Empfangstaktperiode T20 wird die Phase der Empfangstaktperiode T20 um ein negatives Phaseninkrement -PI verschoben. Anschließend ist die Phasenverschiebung dP negativ, weshalb die Phase der Empfangstaktperiode T20 um ein positives Phaseninkrement PI verschoben wird etc.

Das Verschieben der Phase der Empfangsaktperiode T20 um ein Phaseninkrement PI kann beispielsweise durch eine Phase-Locked-Loop erfolgen.

Die Empfangstaktfrequenz f20 wird durch das Verschieben der Phasenlage der Empfangstaktfrequenz T20 zwar asynchron zur Zählertaktfrequenz f2. Da die Phasenverschiebungen dP aber bekannt sind, können sie bei der weiteren Verarbeitung berücksichtigt werden.

Besonders vorteilhaft ist es, wenn zusätzlich zur Änderung der Phase der Empfangstaktperiode T20 auch der Zählerstand des Empfangszählers Z20 um eine Zählerdifferenz dZ entsprechend der Phasenverschiebung dP verändert wird, d.h. bei einer positiven Phasenverschiebung dP um eine Zählerdifferenz dZ=dP verlängert und bei einer negativen Phasenverschiebung dP um eine Zählerdifferenz dZ=dP verkürzt wird. Insbesondere, wenn die Phasenverschiebung dP um ein Phaseninkrement PI (entsprechend einem Zählerinkrement I20) verändert wird, wird dann die die Zählerdifferenz dZ um das Zählerinkrement I20 verändert. In Fig. 2 erfolgt immer jeweils eine Änderung der Phasenverschiebung dP um ein Phaseninkrement PI und ebenso eine äquivalente Änderung des Zählerstands des Empfangszählers Z20 um ein Zählerinkrement I20 in der Höhe eines Phaseninkrements PI. Würde der Zählerstand des Empfangszählers Z20 in Fig. 2 nicht angepasst werden, dann würde der Empfangszähler nicht mehr in der lokalen Zeit t2 quantisiert werden.

Durch die Anpassung des Empfangszählers Z20 wird sichergestellt, dass die lokale Zeit t2 auch nach der Phasenverschiebung dP durch den Empfangszähler Z20 weiterhin korrekt abgebildet wird. In Fig. 2 erfolgt die Änderung der Phasenlage und des Zählerstands des Empfangszählers Z20 in derselben Empfangstaktperiode T20 des Empfangszählers Z20. Es kann der Zählerstand jedoch auch in einer späteren Empfangstaktperiode T20 um die Zählerdifferenz dZ, oder auch stückweise über mehrere Zählerinkremente I20, verändert werden. Natürlich ist das Anwenden der addierten Zählerdifferenz dZ nur möglich, wenn der Empfangszählers Z20 eine Auflösung aufweist, die größer als eine Empfangsfrequenz f20 ist. Es kann beispielsweise eine Auflösung von 1 µs / 2^16, d.h. ca. 15,26 ps vorgesehen sein, was einer Frequenz von 65,536 GHz entspricht. Damit ist die Auflösung 256-mal höher als die Empfangstaktfrequenz f20. Entspricht die Phasenverschiebung dP z.B. einem 24stel der Empfangstaktperiode T20, so entspricht die Zählerdifferenz dZ 65,536 GHz / (256 MHz * 24) = 10,6 (6 ist periodisch) korrigiert werden. Um eine Akkumulierung von Rundungsfehlern zu vermeiden, werden vorzugsweise alle Nachkommastellen berücksichtigt und die Zählerdifferenz dZ exakt auf die Phasenverschiebung dP abgestimmt.

Der Empfangszähler Z20 benötigt eine Auflösung, welche mindestens der Zählerdifferenz dZ entspricht. Insbesondere für eine Verwendung digitaler Filter ist eine noch höhere Auflösung wünschenswert. Weist der Empfangszähler Z20 eine Empfangstaktfrequenz f20 von 51,2 MHz auf, so wird dieser bei einer Auflösung von 15,26 ps in einer Empfangstaktperiode T20 1280-mal inkrementiert.

Der Empfangszähler Z20 und der Zähler Z2 bilden also dieselbe lokale Zeit t2 ab und sind daher "wertsynchron", obwohl die Empfangstaktfrequenz f20 und die Zählertaktfrequenz f2 asynchron sind. Da die Phasenverschiebungen aber bekannt sind und vor der Clock-Data-Recovery angeordnet sind, können sie bei der weiteren Verarbeitung berücksichtigt werden.

In der Realität weisen die Oszillatoren von Zählern eine maximale Abweichung von +/- 50 ppm auf, womit zwei Signale maximal um 100 ppm abweichen können. Damit ist es ausreichend, wenn die (akkumulierte) Phasenverschiebung dP nicht nach jedem Zählerinkrement I20 des Empfangszählers Z20 korrigiert wird. Es ist somit vorteilhaft, wenn die Phasenverschiebung dP erst nach Überschreiten einer maximalen Phasenabweichung, vorzugsweise in der Höhe eines halben Phaseninkrements PI, korrigiert wird.

## Patentansprüche

1. Verfahren zum Empfang eines Signals (S) durch einen Teilnehmer (12) eines Echtzeit-Netzwerks (1), wobei das Signal (S) einen Signaltakt (ZT11) mit einer Signaltaktfrequenz (f11) aufweist und der Teilnehmer (12) einen Zähler (Z2) umfasst, welcher einen Zählertakt (ZT2) mit einer Zählertaktfrequenz (f2) aufweist und eine lokale Zeit (t2) des Teilnehmers (12) abbildet, wobei ein Empfangstakt (ZT20) eines Empfangszählers (Z20) des Teilnehmers (12) zur Abtastung des Signals (S) vorgesehen ist und der Empfangstakt (ZT20) aus dem Zählertakt (ZT2) abgeleitet wird, womit der Empfangszähler (Z20) die lokale Zeit (t2) des Teilnehmers (12) abbildet, wobei eine Phasenlage des Empfangstakts (ZT20) bei der Ableitung aus dem Zählertakt (ZT2) an die Phasenlage des Signaltakts (ZT11) angepasst wird, und wobei das Signal (S) mit einer Empfangstaktfrequenz (f20) des Empfangszählers (Z20) abgetastet wird.

2. Verfahren nach Anspruch 1, **dadurch gekennzeichnet, dass** der Empfangstakt (ZT20) unter Verwendung einer Phase-Locked-Loop aus dem Zählertakt (ZT11) abgeleitet wird

3. Verfahren nach einem der Ansprüche 1 bis 2, **dadurch gekennzeichnet, dass** die Empfangstaktfrequenz (f20) des Empfangstakts (ZT20) einer Zählertaktfrequenz (f2) des Zählertakts (ZT2) entspricht.

4. Verfahren nach einem der Ansprüche 1 bis 2, **dadurch gekennzeichnet, dass** eine Empfangstaktfrequenz (f20) des Empfangstakts (ZT20) ein Vielfaches einer Zählertaktfrequenz (f2) des Zählertakts (ZT2) ist.

5. Verfahren nach einem der Ansprüche 1 bis 4, **dadurch gekennzeichnet, dass** ein Vorzeichen einer Phasenverschiebung (dP) zwischen dem Empfangstakt (ZT20) und dem Signaltakt (ZT11) ermittelt wird, und darauf basierend die Phasenlage des Empfangstakts (ZT20) verändert wird, um die Phasenlage des Empfangstakts (ZT20) an die Phasenlage des Signaltakts (ZT11) anzupassen.

6. Verfahren nach Anspruch 5, **dadurch gekennzeichnet, dass** die Phasenlage des Empfangstakts (ZT20) für jede Empfangstaktperiode (T20) verändert wird.

7. Verfahren nach einem der Ansprüche 1 bis 6, **dadurch gekennzeichnet, dass** die Phasenlage des Empfangstakts pro Empfangstaktperiode (T20) durch Verschiebung um ein positives oder negatives Phaseninkrement (PI) verändert wird.

8. Verfahren nach einem der Ansprüche1 bis 7, **dadurch gekennzeichnet, dass** der Zählerstand des Empfangszählers (Z20) analog zur Phasenlage des Empfangstakts (ZT20) verändert wird.

9. Verfahren nach einem der Ansprüche 1 bis 8, **dadurch gekennzeichnet, dass** der Teilnehmer (12) den Signaltakt (ZT11) aus dem Signal (S) rekonstruiert.

10. Verfahren nach Anspruch 9, **dadurch gekennzeichnet, dass** das Signal (S) leitungscodiert ist.

11. Verfahren nach Anspruch 10, **dadurch gekennzeichnet, dass** das Signal (S) mit der 8B10B-Leitungscodierung codiert ist.

## Claims

1. A method for receiving a signal (S) by a subscriber (12) of a real-time network (1), the signal (S) having a signal clock (ZT11) having a signal clock frequency (f11) and the subscriber (12) comprising a counter (Z2), which comprises a counter clock (ZT2) having a counter clock frequency (f2) and which maps a local time (t2) of the subscriber (12), **wherein** a reception clock (ZT20) of a reception counter (Z20) of the subscriber (12) is provided for sampling the signal (S) and the reception clock (ZT20) is derived from the counter clock (ZT2), whereby the reception counter (Z20) maps the local time (t2) of the subscriber (12), **wherein** a phase position of the reception clock (ZT20) is adapted to the phase position of the signal clock (ZT11), when said reception clock is derived from the counter clock (ZT2), **and wherein** the signal (S) is sampled at a reception clock frequency (f20) of the reception counter (Z20).

2. The method according to claim 1, **characterized in that** the reception clock (ZT20) is derived from the counter clock (ZT11) using a phase-locked loop.

3. The method according to any of claims 1 to 2, **characterized in that** the reception clock frequency (f20) of the reception clock (ZT20) corresponds to a counter clock frequency (f2) of the counter clock (ZT2).

4. The method according to any of claims 1 to 2, **characterized in that** a reception clock frequency (f20) of the reception clock (ZT20) is a multiple of a counter clock frequency (f2) of the counter clock (ZT2).

5. The method according to any of claims 1 to 4, **characterized in that** a sign of a phase shift (dP) between the reception clock (ZT20) and the signal clock (ZT11) is determined, and based on this the phase position of the reception clock (ZT20) is changed to adapt the phase position of the reception clock (ZT20) to the phase position of the signal clock (ZT11).

6. The method according to claim 5, **characterized in that** the phase position of the reception clock (ZT20) is changed for each reception clock period (T20).

7. The method according to any of claims 1 to 6, **characterized in that** the phase position of the reception clock per reception clock period (T20) is changed by shifting said phase position by a positive or negative phase increment (PI).

8. The method according to any of claims 1 to 7, **characterized in that** the counter reading of the reception counter (Z20) is changed analogously to the phase position of the reception clock (ZT20).

9. The method according to any of claims 1 to 8, **characterized in that** the subscriber (12) reconstructs the signal clock (ZT11) from the signal (S).

10. The method according to claim 9, **characterized in that** the signal (S) is line-coded.

11. The method according to claim 10, **characterized in that** the signal (S) is coded with the 8B10B line coding.

## Revendications

1. Procédé de réception d'un signal (S) par un participant (12) d'un réseau temps réel (1), le signal (S) présentant une horloge de signal (ZT11) ayant une fréquence d'horloge de signal (f11) et le participant (12) comprenant un compteur (Z2) qui présente une horloge de compteur (ZT2) ayant une fréquence d'horloge de compteur (f2) et représentant un temps local (t2) du participant (12), une horloge de réception (ZT20) d'un compteur de réception (Z20) du participant (12) étant prévue pour l'échantillonnage du signal (S) et l'horloge de réception (ZT20) étant dérivée de l'horloge de compteur (ZT2), ce qui permet au compteur de réception (Z20) de représenter le temps local (t2) du participant (12), une position de phase de l'horloge de réception (ZT20) étant adaptée à la position de phase de l'horloge de signal (ZT11) lors de la dérivation effectuée à partir de l'horloge de compteur (ZT2), et le signal (S) étant échantillonné à une fréquence d'horloge de réception (f20) du compteur de réception (Z20).

2. Procédé selon la revendication 1, **caractérisé en ce que** l'horloge de réception (ZT20) est dérivée de l'horloge de signal (ZT11) par utilisation d'une boucle à verrouillage de phase.

3. Procédé selon l'une des revendications 1 à 2, **caractérisé en ce que** la fréquence d'horloge de réception (f20) de l'horloge de réception (ZT20) correspond à une fréquence d'horloge de compteur (f2) de l'horloge de compteur (ZT2).

4. Procédé selon l'une des revendications 1 à 2, **caractérisé en ce qu'**une fréquence d'horloge de réception (f20) de l'horloge de réception (ZT20) est un multiple d'une fréquence d'horloge de compteur (f2) de l'horloge de compteur (ZT2).

5. Procédé selon l'une des revendications 1 à 4, **caractérisé en ce qu'**un signe d'un déphasage (dP) entre l'horloge de réception (ZT20) et l'horloge de signal (ZT11) est déterminé, et **en ce que** sur cette base, la position de phase de l'horloge de réception (ZT20) est modifiée pour adapter la position de phase de l'horloge de réception (ZT20) à la position de phase de l'horloge de signal (ZT11).

6. Procédé selon la revendication 5, **caractérisé en ce que** la position de phase de l'horloge de réception (ZT20) est modifiée pour chaque période d'horloge de réception (T20) .

7. Procédé selon l'une des revendications 1 à 6, **caractérisé en ce que** la position de phase de l'horloge de réception est modifiée par période d'horloge de réception (T20) par décalage d'un incrément de phase (PI) positif ou négatif.

8. Procédé selon l'une des revendications 1 à 7, **caractérisé en ce que** le compteur de réception (Z20) est modifié de manière analogue à la position de phase de l'horloge de réception (ZT20).

9. Procédé selon l'une des revendications 1 à 8, **caractérisé en ce que** le participant (12) reconstruit l'horloge de signal (ZT11) à partir du signal (S).

10. Procédé selon la revendication 9, **caractérisé en ce que** le signal (S) est codé en ligne.

11. Procédé selon la revendication 10, **caractérisé en ce que** le signal (S) est codé avec le codage en ligne 8B10B.
